# EUROPEAN PATENT APPLICATION

(11) **EP 2 330 636 A2**
(43) Date of publication of application: **08.06.2011**
(21) Application number: 10251961.8
(22) Date of filing: 18.11.2010
(51) Int. Cl.: H01L 31/052

(54) **Dye-sensitized solar concentrator module**

(30) Priority: 01.12.2009 KR 20090117835
(71) Applicant: Samsung SDI Co., Ltd., Yongin-si, Gyeonggi-do (KR)
(72) Inventor: Kwak, Dong-Sik, Yongin-si Gyeonggi-do (KR)
(74) Representative: Mounteney, Simon James

(57) **Abstract**

A solar battery module. The solar battery module includes at least one three-dimensional solar battery unit formed of one or more dye-sensitized solar battery cells. The three-dimensional solar battery unit may be disposed on an optical element configured to utilize light penetrated through the three-dimensional solar battery unit. The optical element may include another solar battery cell or a reflective plate.

## Description

One or more embodiments of the present invention relate to a dye-sensitized solar battery, and more particularly, to a three-dimensional dye-sensitized solar battery module.

Solar batteries generating electric energy by using solar energy, which is a renewable energy source, are environmentally friendly and have a long lifespan.

Currently most commercialized solar batteries are silicon solar batteries. However, a manufacturing cost of the silicon solar batteries is high, and it is hard to improve their efficiency. Accordingly, dye-sensitized solar batteries (i.e., DSSCs) have recently been highlighted as next generation solar batteries for replacing the current silicon solar batteries.

A dye-sensitized solar battery is a photoelectrochemical solar battery which mainly includes photosensitive dye molecules and a metal oxide electrode. Here, in one embodiment, the photosensitive dye molecules generate electron-hole pairs by absorbing visible rays of light, and the metal oxide electrode transmits the generated electrons to an outside circuit. In general, a plurality of dye-sensitized solar battery cells may be connected in series to form a module. Since a dye-sensitized solar battery may be produced by using a more simple process than that of the silicon solar battery, a manufacturing cost thereof may be significantly reduced. Also, a dye-sensitized solar battery is transparent and becomes more efficient as the temperature thereof increases.

However, photoelectric conversion efficiency of a dye-sensitized solar battery is low, for example, about 11 to 12 %. In order to improve the photoelectric conversion efficiency of a dye-sensitized solar battery, studies on improving characteristics of dye-sensitized solar battery materials such as dyes, electrodes, and electrolytes have been performed.

An aspect of an embodiment of the present invention is directed toward a dye-sensitized solar battery (DSSC) module having improved electricity generation per unit installation area.

Additional aspects of embodiments of the present invention will be set forth in part in the description which follows and, in part, will be apparent from the description, or may be learned by practice of the presented embodiments.

According to one or more embodiments of the present invention, a solar battery module includes a three-dimensional solar battery unit on a first region of a plane, the three-dimensional solar battery unit having a surface area larger than that of the first region and comprising one or more dye-sensitized solar battery cells. The plane may be a substrate

The first region may be a portion of an optical element configured to utilize light penetrated through the three-dimensional solar battery unit.

The optical element may be planar.

The optical element may include another solar battery cell or a reflective plate.

The other solar battery cell may be a dye-sensitized solar battery cell, a silicon solar battery cell, and/or a compound semiconductor solar battery cell.

The other solar battery cell may be disposed on a reflective substrate and/or a transparent substrate.

The three-dimensional solar battery unit may have a line pattern.

A cross-section of the three-dimensional solar battery unit may have an angular shape.

A cross-section of the three-dimensional solar battery unit may have a round shape.

A cross-section of the three-dimensional solar battery unit may have a shape including a round portion and a straight line portion.

The three-dimensional solar battery unit may have a dot pattern. In this case, the three-dimensional solar battery unit may have a pyramid shape or a hemisphere shape.

The three-dimensional solar battery unit may include a plate type element, the plate type element including a dye-sensitized solar battery cell or a cell module composed of a plurality of dye-sensitized solar battery cells.

The solar battery module may include multiple ones of the three-dimensional solar battery units as described above.

The accompanying drawings, together with the specification, illustrate embodiments of the present invention, and, together with the description, serve to explain the principles of the present invention.

FIGS. 1, 2, 3, 4, 5 and 6 are perspective views of dye-sensitized solar battery modules according to embodiments of the present invention;

FIG. 7 is a simulation graph showing the amount of electricity generation according to an incident angle of light of dye-sensitized solar batteries according to an embodiment of the present invention and a comparative example; and

FIG. 8 is a cross-sectional view of a cell included in a dye-sensitized solar battery module according to an embodiment of the present invention.

Hereinafter, a dye-sensitized solar battery module according to embodiments of the present invention will be described more fully with reference to the accompanying drawings. In the drawings, the thicknesses of layers and regions are exaggerated for clarity and like reference numerals denote like elements.

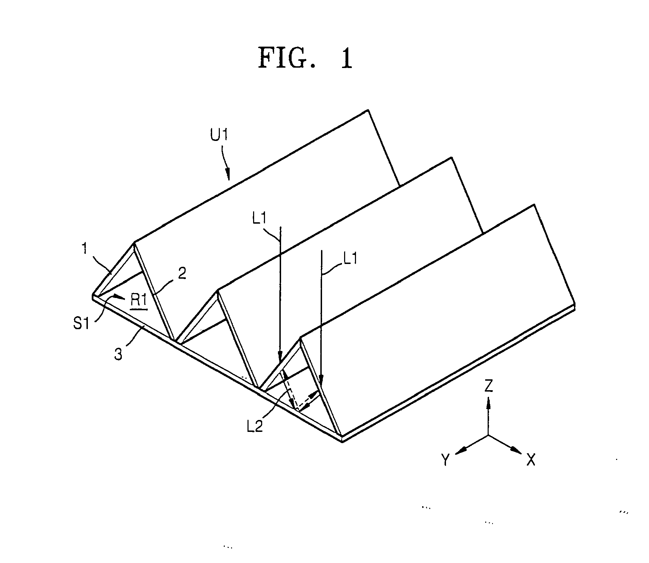

FIG. 1 is a perspective view of a dye-sensitized solar battery module according to an embodiment of the present invention.

Referring to FIG. 1, a plurality of three-dimensional solar battery units U1 is disposed on a set or predetermined plane (hereinafter, referred to as a first plane) S1. The first plane S1 may be a horizontal/XY plane. The plurality of three-dimensional solar battery units U1 may be uniformly arranged. Here, a region of the first plane S1 on which a three-dimensional solar battery unit U1 is disposed is a first region R1, and the three-dimensional solar battery unit U1 has a surface area larger than that of the first region R1. That is, a top surface of the three-dimensional solar battery unit U1 is larger in area than the first region R1. Each of the three-dimensional solar battery units U1 may be formed of one or more dye-sensitized solar battery cells.

The three-dimensional solar battery units U1 may have an angular pillar shape extending in a set or predetermined direction, for example, a Y-axis direction. In this case, the three-dimensional solar battery units U1 may include first and second portions 1 and 2 inclined with respect to the first plane S1. The first and second portions 1 and 2 may be plate type elements. Edges of the first and second portions 1 and 2 may touch each other and opposite edges thereof are spaced apart from each other and may contact two ends of the first region R1. Thus, spaces surrounded by the first and second portions 1 and 2 and the corresponding first region R1 have a triangular pillar form. The first and second portions 1 and 2 may each include one dye-sensitized solar battery cell or a cell module in which a plurality of dye-sensitized solar battery cells are connected. The forms of the first region R1 and the three-dimensional solar battery units U1 may be changed in various suitable ways.

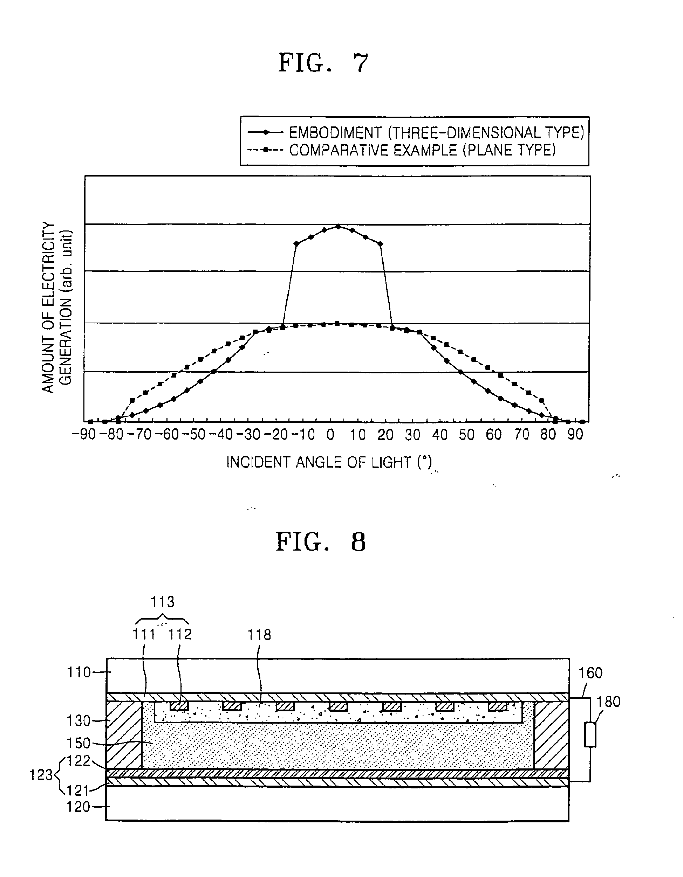

For example, in one embodiment, the structure of a dye-sensitized solar battery cell (i.e., a unit cell of DSSC) that may be included in the first and second portions 1 and 2 is illustrated in FIG. 8.

Referring to FIG. 8, first and second substrates 110 and 120 are spaced a set or predetermined distance apart from each other by a sealing member 130 interposed therebetween. A first electrode 113 is disposed on an inner surface of the first substrate 110 (i.e., on the surface facing the second substrate 120), and a second electrode 123 is disposed on an inner surface of the second substrate 120 (i.e., on the surface facing the first substrate 110). A semiconductor layer 118 to which a photosensitive dye that is excited by light is adsorbed is disposed on the first electrode 113, and an electrolyte layer 150 is interposed between the semiconductor layer 118 and the second electrode 123. The first electrode 113 may include a first transparent conductive layer 111 and mesh-patterned grid electrodes 112 formed on the first transparent conductive layer 111. The grid electrodes 112 are used to reduce electric resistance of the first electrode 113. The second electrode 123 includes a second transparent conductive layer 121 and a catalyst layer 122 formed on the second transparent conductive layer 121. The catalyst layer 122 is formed of a material having a reduction catalyst function which provides electrons to the electrolyte layer 150. In some cases, additional grid electrodes may be disposed on the catalyst layer 122. The first electrode 113 and the second electrode 123 may be electrically connected to each other through a conductive wire 160 and an external circuit 180. In one embodiment, if a plurality of solar battery cells having the structure described with respect to FIG. 8 are connected to each other in series or in parallel, the first electrodes 113 and the second electrodes 123 of the cells are connected to each other in series or in parallel, and ends thereof are connected to the external circuit 180. A dye-sensitized solar battery cell (i.e., a unit cell of DSSC) having such a structure may be used as a basic element of the first and second portions 1 and 2 illustrated in FIG. 1. That is, the first and second portions 1 and 2 illustrated in FIG. 1 may each include a dye-sensitized solar battery cell having the structure described with respect to FIG. 8 or a plurality thereof connected as a cell module. However, the structure of the cell of FIG. 8 is only an example and may suitably vary.

Referring back to FIG. 1, the three-dimensional solar battery units U1 may be disposed on a set or predetermined optical element. The set or predetermined optical element may be an element configured to utilize (or for using) the light that penetrated through the three-dimensional solar battery units U1. That is, the first region R1 may be a portion of the optical element for using the light that penetrated through the three-dimensional solar battery units U1. In FIG. 1, a reflective plate 3 may be the optical element.

As such, if the dye-sensitized solar battery module (including the three-dimensional solar battery units U1) is three-dimensionally formed, effective electricity generation per unit installation area thereof may be greater than that of a plane-type module. In particular, since a dye-sensitized solar battery is transparent, the reflective plate 3 is disposed below the three-dimensional solar battery units U1 of the dye-sensitized solar battery module as illustrated in FIG. 1 so that light penetrating the dye-sensitized solar battery module is reflected by the reflective plate 3 and is incident onto the three-dimensional solar battery units U1 of the dye-sensitized solar battery module again. Accordingly, in the dye-sensitized solar battery module, electricity is generated not only by incident light L1 but also by light (hereinafter, referred to as reflected light) L2 reflected by the reflective plate 3. Thus, the amount of electricity generation per unit installation area may further increase when the dye-sensitized solar battery module is three-dimensionally formed. However, in a general silicon-based solar battery or a compound semiconductor-based solar battery, light does not penetrate and thus an efficiency increase due to light penetration and reflection is not to be expected.

Unlike a silicon solar battery using ultraviolet rays, a dye-sensitized solar battery uses visible light. In this regard, efficiency deterioration due to a change in incident angle is high in a silicon solar battery, whereas a change in efficiency (deterioration) due to a change in incident angle is not high in a dye-sensitized solar battery. Accordingly, although the dye-sensitized solar battery module is three-dimensionally formed as illustrated in FIG. 1, electricity may be generated with relatively uniform efficiency regardless of an incident angle of solar light. Also, efficiency of a silicon solar battery decreases when the temperature thereof increases; however, efficiency of a dye-sensitized solar battery can even increase when the temperature thereof increases. For example, when temperature increases from 25□ to 45□, the efficiency of a silicon solar battery decreases by about 10 %, whereas the efficiency of a dye-sensitized solar battery increases by about 5 %. In addition, electricity is generated only by direct light in a silicon solar battery, whereas electricity is generated by not only direct light but also by radiant light in a dye-sensitized solar battery. Accordingly, when a module of the dye-sensitized solar battery is three-dimensionally formed, efficiency thereof can be significantly increased.

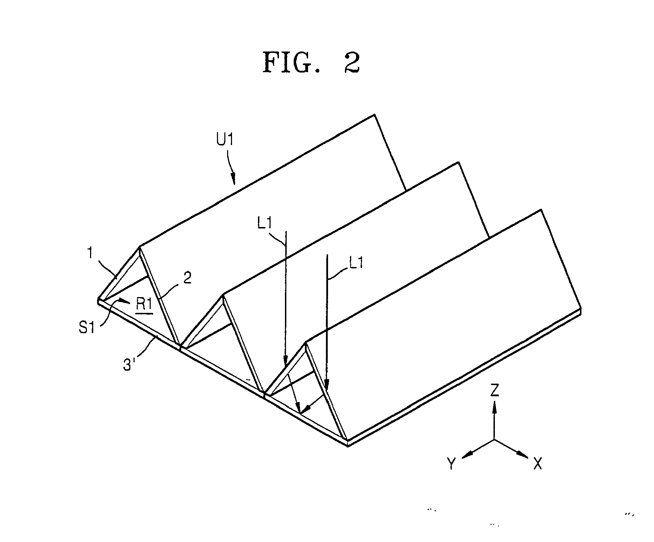

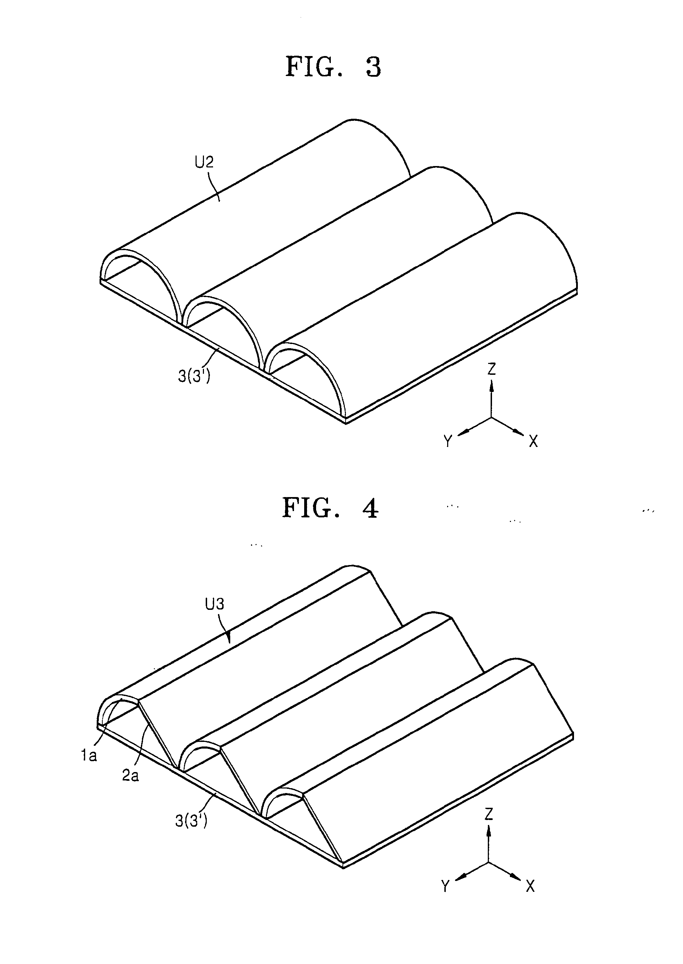

According to another embodiment of the present invention, the reflective plate 3 illustrated in FIG. 3 can be replaced with another optical element. For example, the reflective plate 3 can be replaced with another suitable solar battery cell or cell module, as illustrated in FIG. 2.

Referring to FIG. 2, the three-dimensional solar battery units U1 is formed on a plane type solar battery unit 3'. The plane type solar battery unit 3' may be one solar battery cell or a cell module including a plurality of solar battery cells. The plane type solar battery unit 3' may include a cell of a suitable dye-sensitized solar battery, a suitable silicon solar battery, or a suitable compound semiconductor solar battery or may include a cell module thereof. Light penetrating the three-dimensional solar battery units U1 is irradiated on the plane type solar battery unit 3' and electricity is generated by the plane type solar battery unit 3'. Although not illustrated, the plane type solar battery unit 3' may be formed on a reflective substrate or a transparent substrate.

When the plane type solar battery unit 3' is formed of a dye-sensitized solar battery cell (or a cell module), the plane type solar battery unit 3' is also transparent. In this case, when a reflective plate is disposed below the plane type solar battery unit 3', light reflected from the reflective substrate may contribute to electricity generation and thus there may be further increase in the amount of electricity generated. When the plane type solar battery unit 3' is formed of a silicon solar battery cell/cell module or a compound semiconductor solar battery cell/cell module, the plane type solar battery unit 3' may function as a reflective plate. In this case, the plane type solar battery unit 3' is not disposed on an additional reflective plate and may be disposed on a transparent substrate (for example, a glass substrate).

A space between the three-dimensional solar battery units U1 and the corresponding first region R1 may be empty. In some cases, at least a portion thereof may be filled with a transparent material (e.g., to improve strength and/or optical characteristics).

In FIGS. 1 and 2, the three-dimensional solar battery units U1 are line-patterned angular pillars extending in the Y-axis direction. However, the three-dimensional solar battery units U1 are not limited thereto, and the form of the three-dimensional solar battery units U1 may suitably vary according to other embodiments of the present invention. For example, the form of the three-dimensional solar battery units U1 may be changed to a round pillar. Also, the three-dimensional solar battery units U1 may have, for example, a pyramid form, a hemisphere form, and/or an embossed form. In this case, the three-dimensional solar battery units U1 may be arranged in a dot pattern. Hereinafter, various other suitable dye-sensitized solar battery modules will be described.

FIG. 3 is a perspective view of a dye-sensitized solar battery module according to another embodiment of the present invention.

Referring to FIG. 3, a plurality of three-dimensional solar battery units U2 may have curved or semicircular cross-section. In this case, the three-dimensional solar battery units U2 may have a partial cylinder form. The three-dimensional solar battery units U2 may be formed of one round dye-sensitized solar battery cell or a plurality of dye-sensitized solar battery cells. In the latter case, the three-dimensional solar battery units U2, which overall have a curved form, may be formed by combining a plurality of plane dye-sensitized solar battery cells. Here, the plane dye-sensitized solar battery cells extend in the Y-axis direction. The three-dimensional solar battery units U2 may be disposed on a reflective plate 3 or a plane type solar battery unit 3'. The reflective plate 3 and the plane type solar battery unit 3' can correspond to the reflective plate 3 of FIG. 1 and the plane type solar battery unit 3' of FIG. 2, respectively, and thus detailed description thereof is not provided again.

FIG. 4 is a perspective view of a dye-sensitized solar battery module according to another embodiment of the present invention. Three-dimensional solar battery units U3 have a round/curved and a planar part.

Referring to FIG. 4, the three-dimensional solar battery units U3 may include round/curved elements 1 a and planar elements 2a. In other words, in the three-dimensional solar battery units U3, a part of the cross-section (cross-section parallel to a XZ plane) is a straight line and another (remaining) part thereof is curved or round. The three-dimensional solar battery units U3 thus has a mixture form including a part of the angular three-dimensional solar battery units U1 of FIG. 1 and a part of the round three-dimensional solar battery units U2 of FIG. 3.

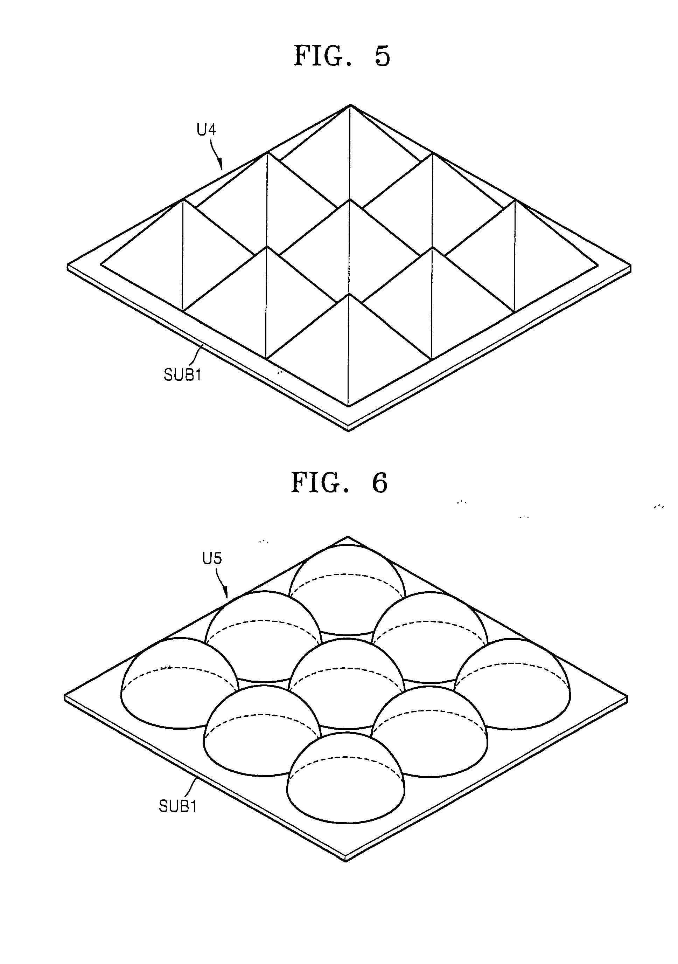

FIG. 5 is a perspective view of a dye-sensitized solar battery module according to another embodiment of the present invention.

Referring to FIG. 5, a plurality of three-dimensional solar battery units U4 are pyramids and are arranged in a dot pattern or a regular array. In this case, an effective electricity generation per unit installation area thereof can be larger than that of FIGS. 1 through 4. Accordingly, the amount of electricity generation per unit installation area may further increase.

In FIG. 5, SUB1 denotes a substrate. The substrate SUB1 may be or may not be a reflective plate. When the substrate SUB1 is a reflective plate, the reflective plate may be the reflective plate 3 of FIG. 1. In FIG. 5 and according to one embodiment, plane type solar battery units are disposed on areas of the substrate SUB1 which correspond to the three-dimensional solar battery units U4, and the three-dimensional solar battery units U4 are disposed on the plane type solar battery units. Here, the plane type solar battery units may be the plane type solar battery units 3' of FIG. 2. Each of the plane type solar battery units may include a cell of a dye-sensitized solar battery, a silicon solar battery, or a compound semiconductor solar battery or may include a cell module thereof. When the three-dimensional solar battery units U4 are disposed on the plane type solar battery units, the substrate SUB1 may be a reflective substrate or a transparent substrate such as a glass substrate.

FIG. 6 is a perspective view of a dye-sensitized solar battery module according to another embodiment of the present invention.

Referring to FIG. 6, three-dimensional solar battery units U5 are hemispheres. Here, each of the three-dimensional solar battery units U5 may be formed of one round dye-sensitized solar battery cell or of a plurality of dye-sensitized solar battery cells. In the latter case, the three-dimensional solar battery units U5, which overall form a hemisphere, may be formed by combining a plurality of planar dye-sensitized solar battery cells. The substrate SUB1 may be or may not be a reflective plate as may be the substrate SUB1 of FIG. 3. Also, planar type solar battery units may be disposed on areas of the substrate SUB1 which correspond to the three-dimensional solar battery units U5. The planar type solar battery unit may include a cell of a dye-sensitized solar battery, a silicon solar battery, or a compound semiconductor solar battery or may include a module thereof.

The forms of the three-dimensional solar battery units described above are only examples. As long as the three-dimensional solar battery units have surface areas greater than that of the first region R1 of FIG. 1, the form thereof may vary.

FIG. 7 is a simulation graph showing the amount of electricity generation according to an incident angle of light of dye-sensitized solar batteries according to an embodiment of the present invention and a comparative example. The simulations are based on the dye-sensitized solar battery according to an embodiment of the present invention according to FIG. 1 with an equilateral triangle cross-section but without the reflective plate 3. That is, electricity generation due to the reflective plate 3 is omitted in this simulation. Also, it is assumed that electricity is generated only by direct light when solar light is incident at an angle between -90 to 90°. That is, it is assumed that a part (shadow part) to which solar light is not directly received does not contribute to electricity generation (however, in actuality, electricity is generated by not only direct light but also by radiant light in the dye-sensitized solar battery and the dye-sensitized solar battery is transparent so that a shadow part does not exist). A dye-sensitized solar battery according to the comparative example is a plane type dye-sensitized solar battery in which a plurality of plane cells are disposed on a substrate. In FIG. 7, when an incident angle is 0°, solar light is radiated directly on top of the dye-sensitized solar battery. When an incident angle is -90°, solar light emits from a left side of the dye-sensitized solar battery. When an incident angle is 90°, solar light emits from a right side of the dye-sensitized solar battery.

Referring to FIG. 7, in ranges of -30 to -90° and 30 to 90°, an amount of electricity generation in the three-dimensional dye-sensitized solar battery (hereinafter, referred to as a three-dimensional solar battery) according to the current embodiment of the present invention is somewhat lower than that of the plane type dye-sensitized solar battery (hereinafter, referred to as a plane solar battery) according to the comparative example, since it is assumed that electricity is generated only by direct light in the solar batteries in the simulation. In the three-dimensional solar battery, areas receiving direct light are small in ranges of incident angle of -30 to -90° and 30 to 90° and thus an amount of electricity generation is somewhat low under the above simulation condition. However, in ranges of 0 to -30° and 0 to 30°, an amount of electricity generation in the three-dimensional solar battery is higher than that of the plane solar battery by about 2 times or more, because electricity generation per installation area in the three-dimensional solar battery is greater than that of the plane solar battery. Here, in a total range from -90 to 90°, a total amount of accumulated electricity generation in the three-dimensional solar battery is higher than that of the plane solar battery by about 14 %. However, such a result is obtained when it is assumed that electricity is generated only by direct light. Also, the functions of the reflective plate 3 of FIG. 1 and the plane type solar battery unit 3' of FIG. 2 are not considered. Accordingly, an amount of light generation in the three-dimensional dye-sensitized solar battery according to the embodiments of the present invention may be significantly greater than the result shown in FIG. 7.

Details are provided above. However, the details may not be construed as limiting the scope of the invention; rather, these details are provided as examples of the embodiments. For example, it should be apparent to one of ordinary skill in the art that the structure and the elements of the dye-sensitized solar battery modules of FIGS. 1 through 6 may be suitably modified and/or vary. For example, the first and second portions 1 and 2 of the three-dimensional solar battery units U1 in FIG. 1 may be disposed at more than one surface of a set or predetermined transparent structure. Here, the first portion 1 and the second portion 2 may or may not directly contact each other. Also, the first and second portions 1 and 2 may or may not directly contact the reflective plate 3.

While the present invention has been described in connection with certain exemplary embodiments, it is to be understood that the invention is not limited to the disclosed embodiments, but, on the contrary, is intended to cover various modifications and equivalent arrangements included within the scope of the appended claims, and - equivalents thereof.

## Claims

1. A solar battery module comprising a three-dimensional solar battery unit on a first region of a plane, the three-dimensional solar battery unit having a surface area larger than that of the first region and comprising one or more dye-sensitized solar battery cells.

2. The solar battery module of claim 1, wherein the first region is a portion of an optical element configured to utilize light penetrated through the three-dimensional solar battery unit.

3. The solar battery module of claim 2, wherein the optical element is planar.

4. The solar battery module of claim 2, wherein the optical element comprises a reflective plate.

5. The solar battery module of claim 2, wherein the optical element comprises another solar battery cell.

6. The solar battery module of claim 5, wherein the other solar battery cell is a dye-sensitized solar battery cell, a silicon solar battery cell, or a compound semiconductor solar battery cell.

7. The solar battery module of claim 5, wherein the other solar battery cell is disposed on a reflective substrate or a transparent substrate.

8. The solar battery module of claim 1, wherein the three-dimensional solar battery unit is elongated.

9. The solar battery module of claim 8, wherein a cross-section of the three-dimensional solar battery unit has an angular shape.

10. The solar battery module of claim 8, wherein a cross-section of the three-dimensional solar battery unit has a round shape.

11. The solar battery module of claim 8, wherein a cross-section of the three-dimensional solar battery unit has a shape comprising a round portion and a straight line portion.

12. The solar battery module of claim 1, wherein the three-dimensional solar battery unit has a dot pattern.

13. The solar battery module of claim 12, wherein the three-dimensional solar battery unit has a pyramid shape or a hemisphere shape.

14. The solar battery module of any preceding claim, wherein the three-dimensional solar battery unit comprises a planar element, the planar element comprising a dye-sensitized solar battery cell or a cell module composed of a plurality of dye-sensitized solar battery cells.

15. The solar battery module of claim 1, wherein the three-dimensional solar battery unit comprises a plurality of three-dimensional solar battery units.
